# EUROPEAN PATENT APPLICATION

(11) **EP 0 571 649 A1**
(43) Date of publication of application: **01.12.1993**
(21) Application number: 92108861.3
(22) Date of filing: 26.05.1992
(51) Int. Cl.: C09J 7/02, H01L 21/68

(54) **Dicing-die bonding film and use thereof in a process for producing chips**

(71) Applicant: NITTO DENKO CORPORATION, Osaka (JP)
(72) Inventor: Akada, Yuzo, c/o Nitto Denko Corporation, Ibaraki-shi, Osaka (JP); Akazawa, Koji, c/o Nitto Denko Corporation, Ibaraki-shi, Osaka (JP); Nakamoto, Keiji, c/o Nitto Denko Corporation, Ibaraki-shi, Osaka (JP)
(74) Representative: Grünecker, Kinkeldey, Stockmair & Schwanhäusser Anwaltssozietät

(57) **Abstract**

A dicing-die bonding film comprising a substrate having formed on one side thereof a pressure-sensitive layer, a first adhesive layer, and a second adhesive layer comprising a thermosetting adhesive showing tackiness at a temperature 150°C or less in this order, the pressure-sensitive layer and the first adhesive layer being peelable from each other, and a process for producing semiconductor chips utilizing the dicing-die bonding film.

## Description

### FIELD OF THE INVENTION

The present invention relates to a dicing-die bonding film which enables separated chips formed by cutting a semiconductor wafer to fix to an adherend with an adhesive layer having good heat resistance. By the use of the film, a simplified chip production process can be attained.

### BACKGROUND OF THE INVENTION

In a conventional process for circuit pattern formation, a semiconductor wafer is cut into chips (dicing step) after decreasing the thickness thereof, if required, by back-side polishing, the separated chips thus formed are fixed to an adherend with an adhesive (mounting step), and the fixed chips are then subjected to a bonding step. In the dicing step, the semiconductor wafer is usually cleaned at an appropriate liquid pressure (normally, about 2 kg/cm²) to remove dust particles formed by the cutting and for other purposes.

The above process, in which coating of an adhesive on the separated chips is necessary, is defective in that it is difficult to form an adhesive layer at a uniform thickness, and adhesive coating necessitates use of a special device and requires much time. A dicing-die bonding film has, therefore, been proposed which, when applied to a semiconductor wafer to support it for cutting, provides the wafer with an adhesive layer for chip fixing and which can thus simplify the conventional process (JP-A-60-57642 which corresponds to US Patent 4,961,804). (The term "JP-A" as used herein means an "unexamined published Japanese patent application".) This dicing-die bonding film comprises a substrate and formed thereon an electrically conductive adhesive layer which is peelable from the substrate. In circuit pattern formation using this dicing-die bonding film, a semiconductor wafer is cut into chips while being supported by the film through the adhesive layer, the substrate is stretched to peel the cut chips from the substrate along with the adhesive layer, and the chips are then collected and separately fixed to an adherend.

However, the above-described dicing-die bonding film has been disadvantageous in that it is difficult to regulate the adhesion strength between the substrate and the conductive adhesive layer. Illustratively stated, it has disadvantageously been difficult to balance an adhesion strength sufficient to avoid interlaminar separation between the substrate and the conductive adhesive layer, which separation, if it occurs during cutting of a semiconductor wafer, may make the cutting impossible or be done erroneously or may cause other troubles, with release properties which enable chips formed by cutting to be easily peeled from the substrate along with the conductive adhesive layer. In particular, it has been difficult to obtain a dicing-die bonding film usable in applications where a high holding power is required, such as in the case of cutting semiconductor wafers with a rotary wheel cutter or the like.

### SUMMARY OF THE INVENTION

An object of the present invention is to provide a dicing-die bonding film which has a well balanced combination of a holding power for supporting a semiconductor wafer during cutting thereof and release properties that enable cut chips to easily peel along with an adhesive layer for separated chip fixing, and which enables separated chips formed using the dicing-die bonding film to strongly bond to an adherend even at a low temperature of 200°C or less and can exhibit excellent high-temperature bonding strength.

The present invention provides a dicing-die bonding film which comprises a substrate having formed on one side thereof a pressure-sensitive layer, a first adhesive layer, and a second adhesive layer comprising a thermosetting adhesive showing tackiness at a temperature of 150°C or more, in this order, the pressure-sensitive layer and the first adhesive layer being peelable from each other.

The present invention also provides a process for producing semiconductor chips which comprises the steps of:
bonding a semiconductor wafer to a dicing-die bonding film comprising a substrate having formed thereon a pressure-sensitive layer, a first adhesive layer, and a second adhesive layer, in this order in the manner such that the semiconductor wafer contacts with the second adhesive layer to support the semiconductor wafer,
cutting the supported semiconductor wafer along with the first and second adhesive layers to form cut chips,
making the pressure-sensitive layer and the first adhesive layer peelable from each other, and
peeling the cut chips from the pressure-sensitive layer along with the first and second adhesive layers, thereby to obtain separated chips.

In the dicing-die bonding film according to the present invention, the substrate functions as the main component which imparts strength to the dicing-die bonding film. The pressure-sensitive layer serves to support the first and second adhesive layers for fixing of separated chips to an adherend, while attaining a good balance between adhesion and release properties. The first adhesive layer serves to strongly bond separated chips to an adherend even at a low temperature of 200°C or less and also functions, with the second adhesive layer, to attain fixing of separated chips with an excellent high-temperature bonding strength (heat resistance). Further, since the first adhesive layer does not show tackiness at around room temperature and has excellent ability to peel from the pressure-sensitive layer, it also enables smooth mounting of separated chips. The second adhesive layer serves to support a semiconductor wafer due to the tackiness thereof.

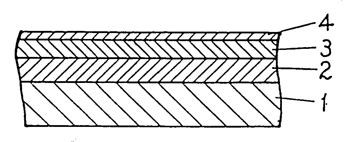

### BRIEF DESCRIPTION OF THE DRAWING

The Figure is a sectional view showing one embodiment of the dicing-die bonding film according to the present invention. In the Figure, 1 is a substrate, 2 is a pressure-sensitive layer, 3 is a first adhesive layer, and 4 is a second adhesive layer.

### DETAILED DESCRIPTION OF THE INVENTION

The substrate is, for example, a film of a plastic or the like. The film can be constituted by at least one layer. Examples of the plastic include polypropylene, polyethylene, polyesters, polycarbonates, ethylene-vinyl acetate copolymers, ethylene-propylene copolymers, ethylene-ethyl acrylate copolymers, and poly(vinyl chloride). A plastic-based substrate having antistatic properties can also be used. Such an antistatic substrate can be obtained by, for example, forming a layer (30 to 500 Å thick) of an electrically conductive material such as a metal, alloy, oxide thereof, or the like on a plastic film with vapor deposition or by laminating this coated film with other films. The substrate preferably comprises a light-transmitting material. The substrate used in the present invention generally has a thickness of from 5 to 200 µm, but the thickness thereof can be determined suitably.

In forming the pressure-sensitive layer, a suitable pressure-sensitive adhesive can be used. In general, the thickness of the pressure-sensitive layer is from 1 to 100 µm, is not particularly limited to this range.

The first adhesive layer is formed using a polymer alloy-type adhesive comprising a thermoplastic resin having a glass transition temperature of 150°C or more and a thermosetting resin. Examples of the thermoplastic resin include polyimide resins, polysulfone resins, and polyethersulfone resins. Examples of the thermosetting resin include epoxy resins, phenolic resins, maleimide resins, and silicone resins. The thickness of the first adhesive layer generally is from 1 to 100 µm, but is not particularly limited to the range.

The pressure-sensitive layer and the first adhesive layer formed in this order on a substrate are peelable from each other. In the present invention, it is preferred that the pressure-sensitive layer and the first adhesive layer are prepared such that the adhesion strength between the two layers in terms of 180° peel strength (room temperature; pulling rate, 300 mm/min) is 200 g/20mm or more during semiconductor wafer cutting and is 150 g/20mm or less during peeling of cut chips, from the standpoints of attaining both of sufficient holding power required during semiconductor wafer cutting and easy peeling of cut chips along with the first and second adhesive layers.

For making the pressure-sensitive layer and first adhesive layer peelable from each other, any method can be used without particular limitation so long as the adhesion strength between the two layers can be reduced or eliminated before cut chips are peeled. For example, the two layers can be made peelable by a method of curing the pressure-sensitive layer, a method of foaming or heat-expanding the pressure-sensitive layer, a method of blooming the pressure-sensitive layer, a method of cooling either the pressure-sensitive layer or the first adhesive layer, or a method of interposing, between the pressure-sensitive layer and first adhesive layer, an adhesion strength-diminishing layer which functions upon heating. In the present invention, these method can be used in suitable combination of two or more thereof.

The method of curing the pressure-sensitive layer is to decrease the adhesion strength by increasing the crosslink density in the pressure-sensitive layer or to generate a stress by shrinking the pressure-sensitive layer through curing. This can be attained by forming the pressure-sensitive layer using a curable pressure-sensitive adhesive such as a ultraviolet-curable type, a heat-curable type or the like.

Representative examples of the ultraviolet-curable pressure-sensitive adhesive include rubber-based or acrylic pressure-sensitive adhesives having blended therewith a photopolymerizable compound such as an addition-polymerizable compound having two or more unsaturated bonds, an alkoxysilane having an epoxy group, or the like, and a photopolymerization initiator such as a carbonyl compound, organosulfur compound, peroxide, amine, onium compound, or the like (JP-A-60-196956). In preparing such the ultraviolet-curable pressure-sensitive adhesive, a photopolymerizable compound and a photopolymerization initiator are generally blended in amounts of from 10 to 500 parts by weight and from 0.05 to 20 parts by weight, respectively, per 100 parts by weight of a base polymer. The acrylic polymer is, for example, an acrylic polymer having a radical-reactive unsaturated group in a side chain (JP-B-61-56264) or an acrylic polymer having an epoxy group in the molecule, besides the acrylic polymers conventionally used (e.g., JP-B-57-54068 and JP-B-58-33909). (The term "JP-B" as used herein means an "examined Japanese patent publication".)

Examples of the addition-polymerizable compound having two or more unsaturated bonds include esters or oligomeric esters of acrylic or methacrylic acid with a polyhydric alcohol, epoxy compounds, and urethane compounds. It is possible to further blend with such the ultraviolet-curable pressure-sensitive adhesive, an epoxy-functional crosslinking agent having one or more epoxy groups in the molecule such as ethylene glycol diglycidyl ether, thereby to increase crosslinking efficiency. In the case of forming an ultraviolet-curable pressure-sensitive layer, a transparent substrate is used to make ultraviolet irradiation treatment possible.

Representative examples of the heat-curable pressure-sensitive adhesive include rubber-based or acrylic pressure-sensitive adhesives which contain a crosslinking agent such as a polyisocyanate, melamine resin, amine-epoxy resin, peroxide, metal chelate compound, or the like and, if required, a crosslinking modifier which is a polyfunctional compound such as divinylbenzene, ethylene glycol diacrylate, trimethylolpropane trimethacrylate, or the like and other ingredients.

The method of foaming or heat-expanding the pressure-sensitive layer is to reduce the adhesion strength by heating the pressure-sensitive layer thereby to cause the layer to have a foamed structure and hence a reduced bonding area, or thereby to roughen the surface of the layer due to expansion of the layer and cause the layer to have a reduced bonding area. This can be attained by blending a foaming agent or heat-expanding agent with the pressure-sensitive layer. Combined use of this method and the above-described curing method is very effective to reduce adhesion strength.

The foaming agent used is the conventional foaming agent. Examples thereof include inorganic foaming agents such as ammonium carbonate and asides, and organic foaming agents such as azo compounds, hydrazine compounds, semicarbazide compounds, triazole compounds, and N-nitroso compounds. The heat-expanding agent used is the conventional one such as microcapsules in which a gas or low-boiling liquid has been encapsulated. Microcapsules of the above kind can also be used as a foaming agent to regulate foaming or expansion of the pressure-sensitive layer, that is, to regulate whether the pressure-sensitive layer is made to have a surface-roughened structure through expansion or to have a foamed structure through foaming, as described hereinabove. Use of microcapsules is preferred because they can be easily dispersed in a pressure-sensitive adhesive. In general, the foaming agent or heat-expanding agent is used in an amount of from 0.3 to 300 parts by weight per 100 parts by weight of a base polymer.

The method of blooming the pressure-sensitive layer is to reduce the adhesion strength by heating the pressure-sensitive layer to rapidly deposit a blooming agent on the interface to the first adhesive layer. This can be attained by blending a blooming agent with the pressure-sensitive layer. Any blooming agent can be used for this purpose so long as it decreases the adhesion strength at the interface to the first adhesive layer. In general, a surfactant, a silicone composition, a low-melting substance such as a paraffin or wax, or the like is used. A liquid such as an organic solvent or water can also be used in the form of microcapsules. Use of a surfactant has an advantage that it is also possible to impart antistatic properties. The blooming agent is generally used in an amount of from 10 to 300 parts by weight per 100 parts by weight of a base polymer.

The method of cooling either the pressure-sensitive layer or the first adhesive layer is to reduce the adhesion strength by lowering the temperature of the layer. This can generally be attained by cooling either of the two layers to a temperature around -30°C. It is possible to use this cooling method after other method has been used to lower the adhesion strength.

The method of interposing an adhesion strength-diminishing layer which functions upon heating is to reduce the adhesion strength at the interface between the pressure-sensitive layer and the first adhesive layer by forming an adhesion strength-diminishing layer as a solid layer between the two layers and heating the adhesion strength-diminishing layer to change the layer. For forming the adhesion strength-diminishing layer, a foaming, heat-expanding, or blooming agent encapsulated in microcapsules as described above, a low-melting substance which becomes soft or flowable upon heating, such as a paraffin or wax, or the like can be used. There is no need to form the adhesion strength-diminishing layer over the entire interface between the pressure-sensitive layer and first adhesive layer, and a coating material for forming the adhesion strength-diminishing layer may, for example, be coated partly or pattern-wise on the surface of the pressure-sensitive layer.

On the first adhesive layer, a second adhesive layer is formed using a thermosetting adhesive showing tackiness at a temperature of 150°C or less, preferably 100 to 15°C, and more preferably 80 to 23°C. The second adhesive layer having such tackiness properties can be formed by, for example, semi-curing a coated thermosetting resin such as an epoxy resin, phenolic resin, polyimide resin, maleimide resin, or silicone resin, to the B-stage state, or by using a pressure-sensitive adhesive obtained by blending a tacky substance having incorporated therein a functional group for crosslinking such as carboxyl group or hydroxyl group and, if required, a crosslinking agent with a thermosetting resin. Examples of the tacky substance having incorporated therein a functional group for crosslinking include pressure-sensitive adhesive-forming polymers such as NBR and acrylic polymers, and tackifier resins such as rosins and terpene resins. In the case of using such a pressure-sensitive adhesive for forming the second adhesive layer, the coated adhesive is semi-cured to the B-stage state according to need. The thickness of the second adhesive layer generally is from 1 to 100 µm, but is not particularly limited to the range.

In the present invention, a fine powder of an electrically conductive material such as aluminum, copper, silver, gold, palladium, or carbon may be contained in the first adhesive layer and/or the second adhesive layer to impart electrical conductivity to the layer(s). Further, a fine powder of a thermally conductive material such as alumina may be contained to enhance thermal conductivity.

The dicing-die bonding film of the present invention is used, for example, in the following manner. A semiconductor wafer is placed on and bonded with the second adhesive layer of the film to fix the wafer. The resulting wafer is cut into chips along with the first and second adhesive layers by suitable means such as a rotary wheel cutter. In this cutting, it is advantageous to leave the substrate uncut from the standpoint of, for example, easy handling of the assembly in subsequent steps. Thereafter, if required and necessary, the assembly is treated to reduce or eliminate the adhesion strength between the pressure-sensitive layer and the first adhesive layer. The cut chips are then peeled from the pressure-sensitive layer along with the first and second adhesive layers. Each of the thus-obtained separated chips is bonded to an adherend such as a lead frame, substrate plate, or the like with the first adhesive layer, and strongly fixed thereto by heat-curing the adhesive layer(s).

Until the dicing-die bonding film is put to practical use, the second adhesive layer side is temporarily coverd with a separator to protect the layer.

According to the present invention, since the dicing-die bonding film has the structure comprising a pressure-sensitive layer and a first and second adhesive layers, in which the pressure-sensitive layer and the first adhesive layer are peelable from each other, the film can support a semiconductor wafer with a sufficient holding power during cutting thereof into chips and, in addition, the thus-formed cut chips can be smoothly peeled along with the first and second adhesive layers due to the good release properties of the first adhesive layer to the pressure-sensitive layer.

Furthermore, the separated chips can be bonded to an adherend with the first and second adhesive layers at a low heating temperature, and the thus-bonded chips can show an excellent high-temperature bonding strength.

The present invention will be explained in more detail by reference to the following examples, but the invention is not construed as being limited thereto.

### EXAMPLE 1

A 50 µm-thick poly(vinyl chloride) film as a substrate was coated with an acrylic ultraviolet-curable pressure-sensitive adhesive to form a pressure-sensitive layer having a thickness of 30 µm.

On the other hand, a methyl ethyl ketone solution of a carboxyl-modified NBR, a bisphenol A epoxy resin (epoxy equivalent 450), a phenolic novolak resin (softening point 75°C), and 2-methylimidazole in a weight ratio of 100/60/30/1 was coated on a separator which was a polyester film treated with a release agent. The coating was dried by heating at 100°C for 10 minutes, thereby to form a second adhesive layer having a thickness of 10 µm.

Further, a dimethylacetamide solution of a polyetherimide, a bisphenol A epoxy resin (epoxy equivalent 185), a phenolic novolak resin (softening point 75°C), and 2-methylimidazole in a weight ratio of 100/50/30/0.5 was coated on a polyester film. The coating was dried by heating at 130°C for 10 minutes under a reduced pressure of 0.5 mmHg, thereby to form a first adhesive layer having a thickness of 20 µm.

The polyester film with the first adhesive layer was press-bonded on the pressure-sensitive layer-coated substrate in a manner such that the first adhesive layer contacted with the pressure-sensitive layer, and the polyester film was then stripped. The separator with the second adhesive layer was press-bonded on the resulting structure in a manner such that the second adhesive layer contacted with the first adhesive layer. Thus, a dicing-die bonding film was obtained.

### EXAMPLE 2

A dicing-die bonding film was obtained in the same manner as in Example 1 except that a first adhesive layer was formed using a polyethersulfone in place of the polyetherimide.

### EXAMPLE 3

A dicing-die bonding film was obtained in the same manner as in Example 1 except that a first adhesive layer was formed using a polysulfone in place of the polyetherimide.

### EXAMPLE 4

A dicing-die bonding film was obtained in the same manner as in Example 1 except that a 100 µm-thick polyester film was used as a substrate, and in place of the ultraviolet-curable pressure-sensitive layer, a heat-foaming pressure-sensitive layer having a thickness of 50 µm was formed on the substrate.

The heat-foaming pressure-sensitive layer was formed by coating the substrate with a toluene-based coating composition containing, dissolved or dispersed in toluene, 100 parts by weight of an acrylic pressure-sensitive adhesive and 20 parts by weight of heat-expanding microspheres (average particle diameter 20 µm) comprising shells made of a vinylidene chloride-acrylonitrile copolymer and isobutane encapsulated in the shells, and drying the coating.

### EXAMPLE 5

A dicing-die bonding film was obtained in the same manner as in Example 1 except that a first adhesive layer was formed using a composition of a polyetherimide, a bisphenol A epoxy resin (epoxy equivalent 185), and 2-methylimidazole in a weight ratio of 100/60/1.

### EVALUATION TEST

The separator was stripped from each of the dicing-die bonding films obtained in the above Examples, and a mirror wafer having a diameter of 4 inches and a thickness of 370 µm was bonded to the exposed second adhesive layer at 60°C by pressing with a roll. The wafer was then cut by full dicing into 3 mm² chips. The cut chips were irradiated on its substrate side with ultraviolet rays through the substrate to cure the pressure-sensitive layer, and each cut chip was then pushed up with a needle and picked up. The thus-obtained separated chips were bonded to a 42 alloy frame at 200°C and then strongly fixed by further heat curing at 200°C for 30 minutes.

As a result, it was ascertained that all the dicing-die bonding films obtained in Examples 1 to 3 functioned satisfactorily, that is, dicing could be conducted without any trouble such as chip scattering, and the first adhesive layer could be easily peeled from the pressure-sensitive layer without any trouble when cut chips were picked up. Moreover, all of the fixed chips had shear bond strengths of 15 kg or more at room temperature and 1.5 kg or more at 200°C, showing that they had sufficient bonding strengths for chip processing.

While the invention has been described in detail and with reference to specific embodiments thereof, it will be apparent to one skilled in the art that various changes and modifications can be made therein without departing from the spirit and scope thereof.

## Claims

1. A dicing-die bonding film comprising a substrate having formed on one side thereof a pressure-sensitive layer, a first adhesive layer, and a second adhesive layer comprising a thermosetting adhesive showing tackiness at a temperature 150°C or less in this order, said pressure-sensitive layer and said first adhesive layer being peelable from each other.

2. A film as claimed in claim 1, wherein said substrate comprises a light-transmitting material.

3. A film as claimed in claim 1, wherein said pressure-sensitive layer comprises a curable pressure-sensitive adhesive.

4. A film as claimed in claim 1, wherein said first adhesive layer comprises a polymer alloy-type adhesive comprising a thermoplastic resin having a glass transition temperature of 150°C or more and a thermosetting resin.

5. A process for producing semiconductor chips which comprises the steps of:
bonding a semiconductor wafer to a dicing-die bonding film comprising a substrate having formed thereon a pressure-sensitive layer, a first adhesive layer, and a second adhesive layer, in this order in the manner such that the semiconductor wafer contacts with the second adhesive layer to support the semiconductor wafer,
cutting the supported semiconductor wafer along with the first and second adhesive layers to form cut chips, making the pressure-sensitive layer and the first adhesive layer peelable from each other, and
peeling the cut chips from the pressure-sensitive layer along with the first and second adhesive layers, thereby to obtain separated chips.
